(19) Europäisches Patentamt
European Patent Office
Office européen des brevets

(11) **EP 2 849 337 B1**

## (12) EUROPEAN PATENT SPECIFICATION

(45) Date of publication and mention
of the grant of the patent:
**29.03.2017 Bulletin 2017/13**

(51) Int Cl.:
*H03F 1/30* *(2006.01)* *H03F 3/181* *(2006.01)*
*H03G 9/16* *(2006.01)*

(21) Application number: **13184506.7**

(22) Date of filing: **16.09.2013**

(54) **Electric amplifier circuit for amplifying an output signal of a microphone**

Elektrische Verstärkerschaltung zur Verstärkung eines Ausgangssignals eines Mikrofons

Circuit amplificateur électrique pour amplifier un signal de sortie d'un microphone

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**18.03.2015 Bulletin 2015/12**

(73) Proprietor: **ams AG
8141 Unterpremstätten (AT)**

(72) Inventor: **Dünser, Wolfgang
8640 Rapperswil-Jona (CH)**

(74) Representative: **Epping - Hermann - Fischer
Patentanwaltsgesellschaft mbH
Schloßschmidstraße 5
80639 München (DE)**

(56) References cited:
**EP-A2- 1 298 795        DE-A1- 2 312 705
JP-A- 2010 118 831        US-A- 4 066 976
US-A- 4 072 906        US-A1- 2010 061 576**

**Description**

Technical Field

The invention is directed to an electric amplifier circuit for amplifying an output signal of a microphone, such as a MEMS (micro electromechanical system) microphone. The invention further concerns a microphone chip including a MEMS microphone.

Background

A microphone chip, such as a MEMS microphone chip, comprises a microphone being coupled to an electric amplifier circuit for amplifying an output signal of the microphone. The microphone and the electric amplifier circuit may be encapsulated in a package. The electric amplifier circuit may be configured as an integrated circuit and particularly as an ASIC (Application-Specific Integrated Circuit). The microphone is coupled to a sensitive input terminal of the electric amplifier circuit to apply the output signal of the microphone. The electric amplifier circuit amplifies the received output signal of the microphone and generates an amplified output signal at an output terminal of the electric amplifier circuit.

The electric amplifier circuit of the microphone chip may comprise an amplifier component, for example, a differential amplifier component having a first input terminal, for example, a positive input terminal to apply the output signal of the microphone and a second input terminal, for example, a negative input terminal to apply a reference signal. Besides the AC output signal of the microphone a DC signal is applied to the first input terminal of the amplifier component which is caused by a circuit for setting a DC operating point of the amplifier component. Due to the inherent structure of the amplifier component not only the AC output signal of the microphone but also the voltage of the DC signal between the first and second input terminals of the amplifier component is also amplified by the amplifier component.

In order to avoid the occurrence of a DC voltage between the first and second input terminals of the amplifier component, a copy of the potential of the DC signal is generated at the second input terminal of the amplifier component and used as an analog ground signal for the amplifier component. However, due to parasitics and tolerances of the components of the electric amplifier circuit a difference between the level of the copy of the DC signal applied at the second input terminal and the level of the DC signal applied at the first input terminal of the amplifier component will still be amplified and thus lowers the maximum swing for the AC output signal of the microphone. In order to reduce the difference between the DC levels at the first and second input terminal of the amplifier component, a feedback path is provided between an output terminal of the amplifier component and the second input terminal of the amplifier component, wherein a filter, for example, a low pass filter is arranged in this feedback path.

The low pass filter in the feedback path results in a high pass in the forward path of the electric amplifier circuit between the input and output terminal of the electric amplifier circuit. The filter in the feedback path causes a phase shift of the output signal generated by the amplifier component at the output terminal of the electric amplifier circuit in the range of lower frequencies. The phase shift also depends on the gain of the amplifier component.

A plurality of microphone chips as described above may be arranged in arrays. Such microphone chips arranged in arrays for active noise cancellation or beam forming need to have a good sensitivity and phase matching of the output signal generated at the output terminal of the electric amplifier circuit of the microphone chip. Different sensitivities or different phase shifts at the respective output terminals of the microphone chips would result in an error by post processing of the output signals of the different microphone chips. It is possible to use unmatched microphones and calibrate the whole array, but this is expensive and would also increase the processing effort.

As phase matching of the output signals of different microphone chips in an array is an important matter, it is desired to provide an electric amplifier circuit in a microphone chip for amplifying an output signal of a microphone where the phase shift of the output signal of the electric amplifier circuit stays constant over the gain setting of the amplifier component of the electric amplifier circuit.

A variable gain amplifier device is described in EP 1 298 795 A2. The variable gain amplifier comprises a feedback circuit in a feedback path of an amplifier circuit. A gain of the amplifier circuit and a lower cutoff frequency of the feedback circuit is controlled by a control circuit.

Summary

An electric amplifier circuit for amplifying an output signal of a microphone is specified in claim 1.

According to an embodiment of an electric amplifier circuit for amplifying an output signal of a microphone, the electric amplifier circuit comprises an input terminal to apply the output signal of the microphone, an output terminal to output an output signal of the amplifier circuit, an amplifier component having a first input terminal for applying a first input signal, a second input terminal for applying a second input signal and an output terminal for outputting an output signal of the amplifier component, wherein the first input terminal of the amplifier component is coupled to the input terminal of the electric amplifier circuit, and the output terminal of the amplifier component is coupled to the output terminal of the electric amplifier circuit. The electric amplifier circuit further comprises a feedback path being coupled between the output terminal of the amplifier component and the second input terminal of the amplifier component and a variable filter circuit having a variable corner frequency. The variable filter circuit is arranged in the feedback path and comprises an electric component being configured for setting the corner frequency of the variable filter circuit.

A microphone chip is specified in claim 15. According to an embodiment of the microphone chip, the chip comprises the electric amplifier circuit as described above, and the microphone. The microphone is coupled to the input terminal of the amplifier circuit. The microphone may be formed as a MEMS microphone.

In microphone chips with a high sensitivity accuracy of the microphone, the electric amplifier circuit for amplifying the output signal of the microphone has usually an integrated trim function which, for example, changes the gain of the amplifier component. The amplifier component in the electric amplifier circuit may be configured as a differential amplifier component. In order to ensure that different microphone chips with different gain settings of their respective amplifier component have the same phase shift between their respective output signal of the microphone applied at the input terminal of the electric amplifier circuit and their respective output signal of the electric amplifier circuit generated at the output terminal of the amplifier circuit, the phase shift between the input and output signal has to stay constant for different gain setting of the amplifier component.

If the corner frequency of the filter in the feedback path would be constant for different gain settings of the amplifier component, the corner frequency of the whole electric amplifier circuit will shift in dependence on the different gain settings of the amplifier component. It is proposed to provide the filter circuit in the feedback path of the electric amplifier circuit as a variable filter circuit having a variable corner frequency. In particular, the amplifier circuit is configured so that the corner frequency of the variable filter circuit in the feedback path is changed reversely compared to the corner frequency of the whole electric amplifier circuit. The variable filter circuit is configured to set the corner frequency of the variable filter circuit in dependence on the gain of the amplifier component of the electric amplifier circuit.

According to a possible embodiment, the gain setting of the amplifier component may be directly used to modify the corner frequency of the variable filter circuit. The gain setting of the amplifier component may be defined by a trim code stored in a storage circuit. A control or decoder circuit for automatic gain control may read out the trim code from the storage circuit and may set the gain of the amplifier component. The control/decoder circuit may drive the variable filter by a control signal to set the corner frequency of the variable filter circuit in dependence on the trim code and thus in dependence on the gain of the amplifier component. The control/decoder circuit may be configured as an automatic gain control circuit which may set the gain of the amplifier component and the corner frequency of the variable filter circuit during operation of the electric amplifier circuit.

According to another embodiment, it is possible to preset the corner frequency of the filter circuit of the electric amplifier circuit by applying an external control signal to the microphone chip. To this purpose, a frequency response between the input signal of the electric amplifier circuit applied at the input terminal of the electric amplifier circuit, i.e. the output signal of the microphone, and the output signal of the electric amplifier circuit at the output terminal of the electric amplifier circuit is measured. The external control signal to preset the corner frequency of the electric amplifier circuit is generated in dependence on the measured frequency response. It is also possible to program a trim register of the electric amplifier circuit or the storage circuit of the electric amplifier circuit in dependence on the measured frequency response and adjust the corner frequency of the variable filter circuit in dependence on the stored trim code by the control/decoder circuit.

It is to be understood that both the foregoing general description and the following detailed description present embodiments and are intended to provide an overview or a framework for understanding the nature and character of the disclosure. The accompanying drawings are included to provide a further understanding, and are incorporated into and constitute a part of this specification. The drawings illustrate various embodiments and, together with the description, serve to explain the principles and operation of the concepts disclosed.

Brief Description of the Drawings

Figure 1A  shows an embodiment of a microphone chip comprising a microphone and an electric amplifier circuit.

Figure 1B  shows a top view to the microphone chip.

Figure 2  shows an embodiment of an electric amplifier circuit for amplifying an output signal of the microphone.

Figure 3  shows an embodiment of a variable filter circuit having a variable corner frequency.

Figure 4  shows another embodiment of an electric amplifier circuit for amplifying an output signal of a microphone.

Figure 5  shows another embodiment of an electric amplifier circuit for amplifying an output signal of a microphone.

Figure 6  shows another embodiment of an electric amplifier circuit for amplifying an output signal of a microphone.

Figure 7 shows another embodiment of an electric amplifier circuit for amplifying an output signal of a microphone.

## Detailed Description

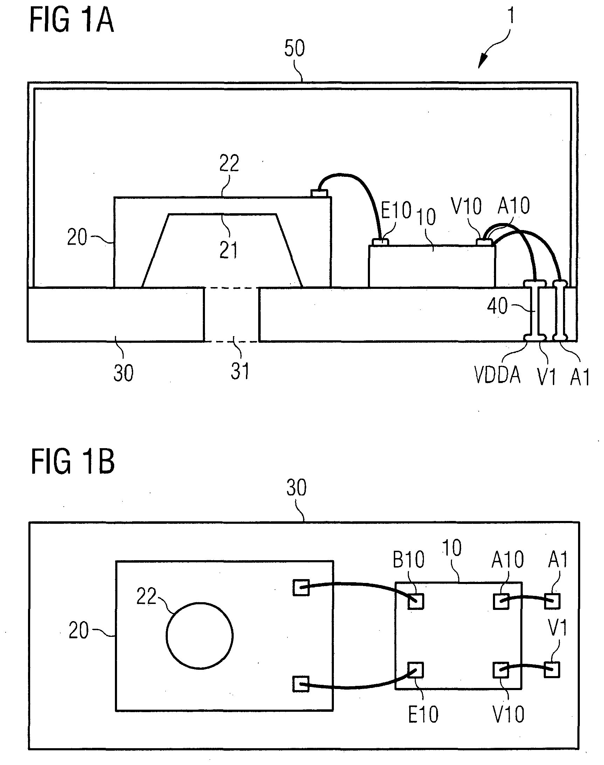

Figure 1A and Figure 1B show a side view and a top view of an embodiment of a microphone chip 1 including a microphone 20, an electric amplifier circuit 10 for amplifying an output signal of the microphone 20, a substrate 30 and a package 50. The microphone and the amplifier circuit are disposed on the substrate 30 and are encapsulated by the package 50. The microphone 20 may be configured as a MEMS (micro electromechanical system) microphone, and the electric amplifier circuit 10 may be configured as an ASIC (application-specific integrated circuit).

The microphone 20 comprises an acoustic-sensitive membrane 21 and a metallic plate 22 which are arranged in a changeable distance to each other. The distance varies in dependence on the acoustic pressure which influences the membrane by an opening 31 of the substrate 30 under the membrane 21. As a result, the capacitance of the microphone 20 changes in dependence on the acoustic pressure. The microphone 20 is connected to a (sensitive) input terminal E10 of the amplifier circuit 10 for receiving an output signal of the microphone. The microphone generates the output signal in dependence on the changed capacitance of the capacitor formed between the membrane 21 and the plate 22. The amplifier circuit 10 amplifies the received output signal of the microphone 20 and generates an amplified output signal at an output terminal A10 of the amplifier circuit which may be tapped at an output pad A1 of the microphone chip 1.

In order to operate the microphone 20 and the amplifier circuit 10, a supply potential VDDA may be applied to an outer terminal/supply bond pad V1 of the microphone chip 1 for applying the supply potential VDDA. The supply bond pad V1 may be disposed on the backside of substrate 30. The supply bond pad is coupled by via hole 40 to a supply input terminal V10 of the electric amplifier circuit 10. The electric amplifier circuit 10 comprises a supply output terminal B10 to provide a bias voltage/current to operate the microphone 20. The microphone 20 is coupled to the amplifier circuit 10 between the supply output terminal B10 and the input terminal E10 of the amplifier circuit.

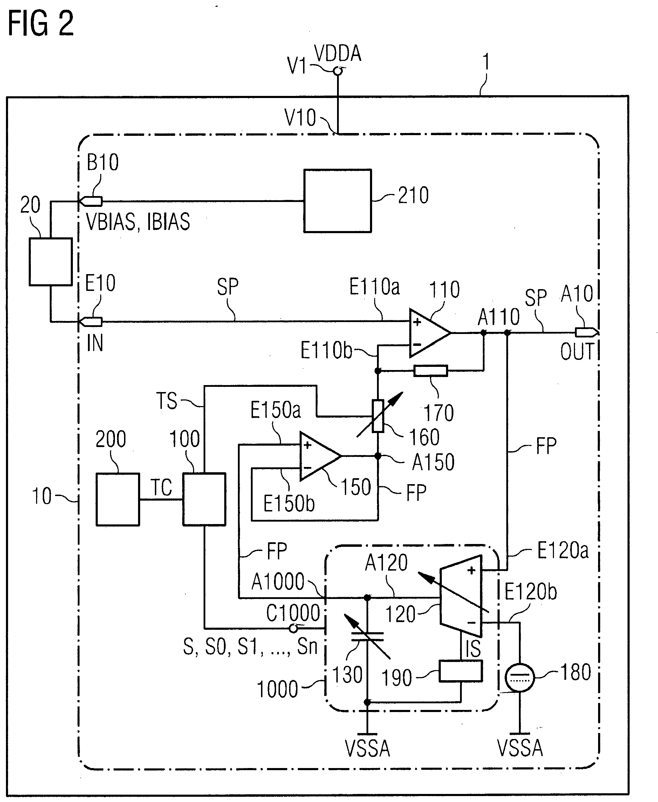

Figure 2 shows an embodiment of the electric amplifier circuit 10 being coupled to the microphone 20. The electric amplifier circuit 10 may be configured as an ASIC. The electric amplifier circuit comprises the supply input terminal V10 to apply the supply potential VDDA. The supply input terminal V10 is coupled to the supply bond pad V1 of the microphone chip 1 for applying the supply potential VDDA.

The electric amplifier circuit 10 comprises a voltage and/or current generator circuit 210 being coupled to the supply input terminal V10 to apply the supply potential VDDA. The voltage and/or current generator circuit 210 is configured to provide a bias voltage VBIAS and/or a bias current IBIAS at the supply output terminal B10 of the amplifier circuit 10 to operate the microphone 20. The microphone 20 is arranged between the supply output terminal B10 and an input terminal E10 of the amplifier circuit 10. During operation the microphone 20 generates an output signal applied to the input terminal E10 of the amplifier circuit 10. The amplifier circuit 10 is configured to amplify the output signal of the microphone 20 and to provide an amplified output signal at the output terminal A10 of the electric amplifier circuit.

The electric amplifier circuit 10 comprises a forward path SP between the input terminal E10 and the output terminal A10. The electric amplifier circuit 10 further comprises an amplifier component 110, for example, a differential amplifier component in the forward path SP. The amplifier component 110 has an input terminal E110a for applying a first input signal, an input terminal E110b for applying a second input signal and an output terminal A110 for generating an output signal OUT of the electric amplifier circuit. In the embodiment of the electric amplifier circuit in which the amplifier component is configured as a differential amplifier component, the input terminal E110a of the differential amplifier component 110 may be configured as a positive input and the input terminal E110b may be configured as a negative input. The input terminal E110a of the amplifier component is connected to the input terminal E10 of the microphone amplifier component 10 which receives the output signal of the microphone 20. The output terminal A110 of the amplifier component is connected to the output terminal A10 of the amplifier circuit 10.

The electric amplifier circuit 10 comprises a feedback path FP being coupled between the output terminal A110 of the amplifier component 110 and the input terminal E110b of the amplifier component 110. The electric amplifier circuit 10 comprises a variable filter circuit 1000 having a variable corner frequency and a voltage follower 150 which are both arranged in the feedback path FP between the output terminal A110 of the amplifier component 110 and the input terminal E110b of the amplifier component 110.

The variable filter circuit 1000 may comprise an amplifier component 120 having an input terminal E120a connected to the output terminal A110 of the amplifier component 110 and another input terminal E120b connected to a voltage source 180 to apply a reference signal Vref to the input terminal E120b of the amplifier component 120. The voltage source 180 is connected between the input terminal E120b of the amplifier component 120 and a terminal to apply a reference potential VSSA. The amplifier component 120 may be configured as a transconductance amplifier component. The variable filter 1000 further comprises a capacitor 130 being connected between the output terminal A120 of the amplifier component 120 and the reference potential VSSA.

An output terminal A1000 of the variable filter 1000 is connected to an input terminal E150a of the voltage follower 150. The voltage follower 150 comprises another input terminal E150b which is coupled to an output terminal A150 of the voltage follower 150. The output terminal A150 of the voltage follower is coupled to the input terminal E110b of the amplifier component 110. The voltage follower 150 is arranged in the feedback path FP between the variable filter 1000 and the input terminal E110b of the amplifier component 110. The input terminal E150a may be configured as a positive input and the input terminal E150b of the voltage follower may be configured as a negative input terminal.

In order to set the gain of the amplifier component 110 the electric amplifier circuit 10 comprises a resistor 160 and a resistor 170. The resistor 160 is arranged in the feedback path FP between the output terminal A150 of the voltage follower 150 and the input terminal E110b of the amplifier component 110. The resistor 170 is directly connected to the output terminal A110 of the amplifier component 110 and the input terminal E110b of the amplifier component 110. The amplifier component 110 is configured such that the gain of the amplifier component is dependent on the relationship between the respective resistance of the resistors 160 and 170. In order to set the gain of the amplifier component 110 at least one of the resistors 160 and 170 may be configured as a variable resistor.

The electric amplifier circuit may comprise a control circuit 100 to set the gain of the amplifier component 110 by modifying the resistance of the resistor 160. The control circuit 100 may be coupled to a storage circuit 200 for storing a value TC, such as a trim code, for specifying the resistance of the variable resistor 160. The control circuit 100 generates a control signal TS for setting the resistance of the variable resistor 160 in dependence on the value TC stored in the storage circuit 200.

In the electric amplifier circuit 10 the phase shift between the input signal IN applied at input terminal E10 and the output signal OUT generated at the output A10 depends on the gain of the amplifier component 110. In order to ensure that microphone chips arranged in an array, wherein the amplifier components 110 of the chips have different gains, have nearly the same phase shift between the input signal IN and the output signal OUT, the corner frequency of the variable filter 1000 is changeable. The control circuit 100 is configured to change the corner frequency of the variable filter so that the corner frequency of the whole electric amplifier circuit 10 stays nearly constant for different gain settings of the amplifier component 110.

The control circuit 100 for setting the resistance of the variable resistor 160 may additionally be configured to control the variable filter 1000 by setting the corner frequency of the variable filter. The control circuit 100 is particularly configured to generate a control signal S or S0, S1, ..., Sn to control the corner frequency of the variable filter 1000. The control circuit 100 is configured to read out the value/trim code specifying the gain of the amplifier component 110 and stored in the storage circuit 200. The control circuit 100 generate the control signal S or S0, S1, ..., Sn to set the corner frequency of the variable filter 1000 in dependence on the read out value/trim code and thus in dependence on the gain of the amplifier component 110.

The variable filter 1000 is configured as a low pass filter. The variable filter 1000 comprises an electric component being configured for setting the corner frequency of the variable filter 1000. The electric component is configured to set the corner frequency of the variable filter circuit 1000 in dependence on the gain of the amplifier component 110. The variable filter 1000 comprises a control terminal C1000 to apply the control signal S or S0, S1, ..., Sn. The electric component of the variable filter 1000 is configured to set the corner frequency of the variable filter 1000 in dependence on the control signal S or S0, S1, ..., Sn received at the control terminal C1000.

According to the embodiment of the variable filter 1000 shown in Figure 2, the variable filter 1000 is configured as a GMC-filter comprising amplifier component 120 and capacitor 130. The electric component for setting the corner frequency of the variable filter 1000 may be configured as a variable amplifier component. According to a possible embodiment the amplifier component 120 is configured as a variable amplifier component having a variable transconductance to set the corner frequency of the variable filter 1000 by modifying the transconductance of the amplifier component 120. The variable filter 1000 is configured to set the transconductance of the variable amplifier component 120 in dependence on the control signal S0, S1,... , Sn generated by the control circuit 100. The variable amplifier component 120 may be configured as an operational transconductance amplifier component. The input terminal E120a may be configured as a positive input and the input terminal E120b may be configured as a negative input of the transconductance amplifier component.

The corner frequency of the variable filter 1000 depends on the transconductance of the variable amplifier component 120. The variable filter 1000 comprises a setting circuit 190 to generate a control signal IS to set the transconductance of the variable amplifier component 120. The setting circuit 190 is configured to generate the control signal IS to set the transconductance of the variable amplifier component 120 in dependence on the control signal S0, S1,..., Sn generated by the control circuit 100 so that the setting circuit 190 generates the control signal IS to set the transconductance of the variable amplifier component 120 in dependence on the gain of the amplifier component 110.

The transconductance gm of the variable amplifier component 120, for example the operational transconductance amplifier component, depends on the provided bias current which is the control signal IS. The corner frequency of the variable filter 1000 can be calcu-

lated with

$$f_C = \cfrac{1}{2\pi * C_1 * \cfrac{1}{gm(IS)}}$$

wherein $C_1$ represents the capacitance of the capacitor 130 and gm specifies the transconductance of the amplifier component 120. The gain of the amplifier component 110 is given by $1 + \dfrac{R_2}{R_1}$, wherein $R_1$ specifies the resistance of resistor 160 and $R_2$ specifies the resistance of resistor 170.

The low pass filter 1000 behaves in the feedback path as a high pass for the input signal IN. The corner frequency of the whole electric amplifier circuit 10 also depends on the gain setting. The relationship between the input signal IN applied at the input terminal E10 and the output signal OUT generated at the output terminal A10 of the electric amplifier circuit may be expressed as

$$OUT(s) = IN(s) * \cfrac{1 + \cfrac{R_2}{R_1}}{1 + \cfrac{R_2}{R_1} * \cfrac{gm(IS)}{s * C_1}},$$

wherein $R_1$ is the resistance of the variable resistor 160, $R_2$ is the resistance of the resistor 170 and $C_1$ is the capacitance of the capacitor 130. The corner frequency of the electric amplifier circuit 10 stays constant, if the ratio of the transconductance gm and the impedance $R_1$ of the variable resistor 160 stays constant for different gain settings of the amplifier component 110. Thus, the bias current IS of the variable amplifier component 110 has to be changed in dependence on the gain setting of the amplifier component 110.

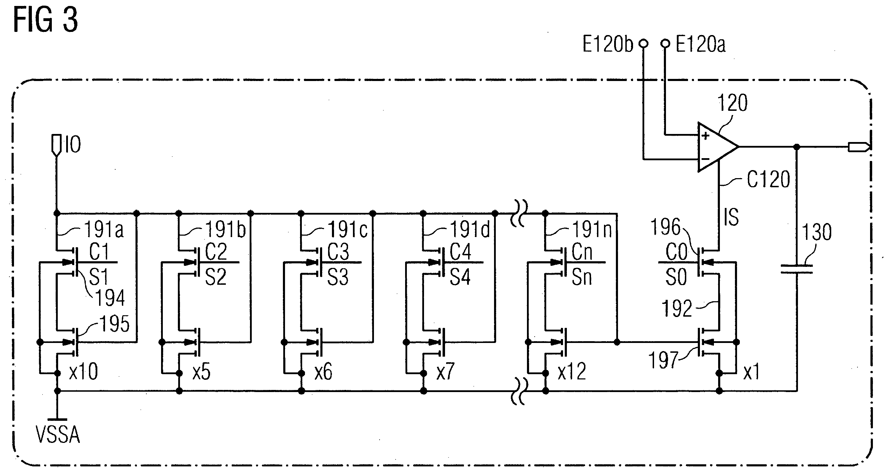

Figure 3 shows an embodiment of the variable filter 1000 comprising the variable amplifier component 120, the capacitor 130 and the setting circuit 190 to generate the control signal IS to set the transconductance gm of the variable amplifier component 120. The setting circuit 190 may be configured to generate the control signal as a bias current IS of the variable amplifier component. The setting circuit 190 may comprise a controllable current mirror circuit comprising current paths 191a, ..., 191n and 192. The setting circuit 190 is configured to set the mirror ratio of the controllable current mirror circuit in dependence on the control signals S0, S1, ..., Sn of the control circuit 100.

Each of the current paths 191a, ..., 191n is arranged between a terminal to apply a current I0 and a

terminal to apply the reference potential VSSA. The current paths 191a, ..., 191n are connected parallel between the terminal to apply a current I0 and the reference potential VSSA. Each of the current paths 191a, ..., 191n comprises a controllable switch 194 which may be configured as a transistor. A respective control terminal C1,... , Cn of each of the controllable switches 194 may be driven by one of the respective control signals S1, ..., Sn. Each of the current paths 191a, ..., 191n further comprises at least one transistor 195. The controllable switch 194 and the transistor 195 are connected in series between the terminal to apply the current I0 and the terminal to apply the reference potential VSSA.

The transistors 195 of each of the current paths 191a, ..., 191n may have the same length/width ratio but may have a different multiplicator. The transistor 195 arranged in the current path 191a may have a multiplicator x10 which means that ten transistors 195 are connected parallel to each other in the current path 191a. The transistor 195 in the current path 191b may have a multiplicator x5 which means that five transistors 195 are connected parallel to each other in the current path 191b. The transistor 195 arranged in current path 191c may have a factor x6 which means that six transistors 195 are connected parallel to each other in the current path 191c. The transistor 195 arranged in current path 191d may have a multiplicator x7 which means that seven transistors 195 are connected parallel to each other in the current path 191d, and the transistor 195 arranged in current path 191n may have a multiplicator x12 which means that twelve transistors 195 are connected parallel to each other in the current path 191n.

The controllable switches 194 of current path 191a, ..., 191n are used to switch the respective current paths in a conductive/non-conductive state. The control signal IS to set the transconductance of the variable amplifier component 120 depends on the current path 191a, ..., 191n being operated in the conductive state. The controllable switches 194 are switched in the conductive/non-conductive state by means of the control signals S1,... , Sn applied to the control terminals C1, ..., Cn. The control signals S1,... , Sn are generated by the control circuit 100 in dependence on the value/trim code stored in the storage circuit 200 and thus in dependence on the gain setting of the amplifier component 110.

A current path 192 is arranged between a control terminal C120 of the variable amplifier component 120 to apply the control signal/bias current IS to set the transconductance gm of the variable amplifier component 120 and the terminal to apply the reference potential VSSA. A controllable switch 196 may be arranged in series with a transistor 197 in current path 192 between the control terminal C120 of the variable amplifier component 120 and the terminal to apply the reference potential. The switch 196 is placed to improve the matching with the other current paths 191a, ..., 191n. In order to switch the current path 192 in a conductive state, a control terminal C0 of the controllable switch 196 may be driven constantly high by a pull up resistor or by the control signal S0 generated by the control circuit 100.

Another possibility to change the corner frequency of the variable filter is to change the mirrors inside the operational transconductance amplifier component. According to another embodiment of the electric amplifier circuit, instead of changing the transconductance gm of the variable amplifier component 120, it is also possible to provide the variable filter with the operational transconductance amplifier component 120 and the capacitor 130, wherein the capacitor 130 is configured as a variable capacitor having a changeable capacitance. In this embodiment of the electric amplifier circuit the capacitance of the capacitor 130 may be changed in dependence on the control signal S generated by the control circuit 100.

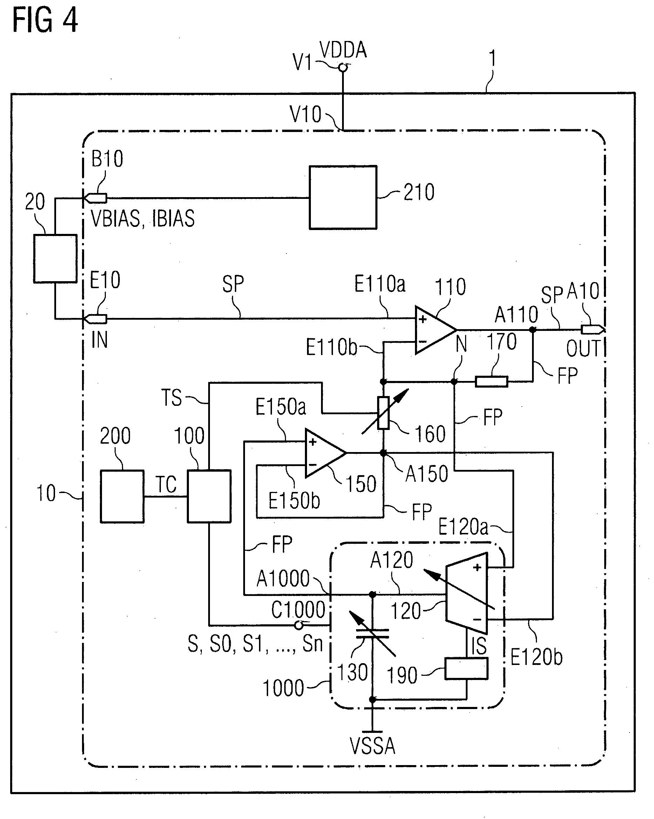

Figures 4, 5 and 6 show other embodiments of the electric amplifier circuit 10 for amplifying the output signal of the microphone 20 comprising the variable filter 1000. Components of the electric amplifier circuit of Figures 4, 5 and 6 being identical to components of the electric amplifier circuit of Figure 2 are referenced by the same signs. For a detailed description of the components referenced in Figures 4, 5 and 6 with the same reference signs as in Figure 2, reference is made to the description of the electric amplifier circuit of Figure 2. In the following only the differences of the embodiments of the electric amplifier circuit of Figures 4, 5 and 6 in relation the embodiment of the electric amplifier circuit shown in Figure 2 are discussed.

In the embodiment of the electric amplifier circuit 10 shown in Figure 4, the input terminal E120a of the amplifier component 120 is connected to a node N between input terminal E110b of the amplifier component 110 and the resistor 170. The feedback path FP take course from the output terminal A110 of the amplifier component 110 via the resistor 170 to the input terminal E120a of the amplifier component 120 and further on via the output terminal A120 of the amplifier component 120 to the voltage follower 150 and via the resistor 160 to the input terminal E110b of the amplifier component 110. The input terminal E120b of the amplifier component 120 is connected to the output terminal A150 of the voltage follower 150. In the embodiment of the electric amplifier circuit 10 of Figure 4, the input terminal E120b of the amplifier component 120 is directly connected to the output terminal A150 of the voltage follower. The amplifier component 120 may be configured as a transconductance amplifier. The input terminal E120a may be configured as the positive input terminal and the input terminal E120b may be configured as the negative input terminal of the transconductance amplifier 120.

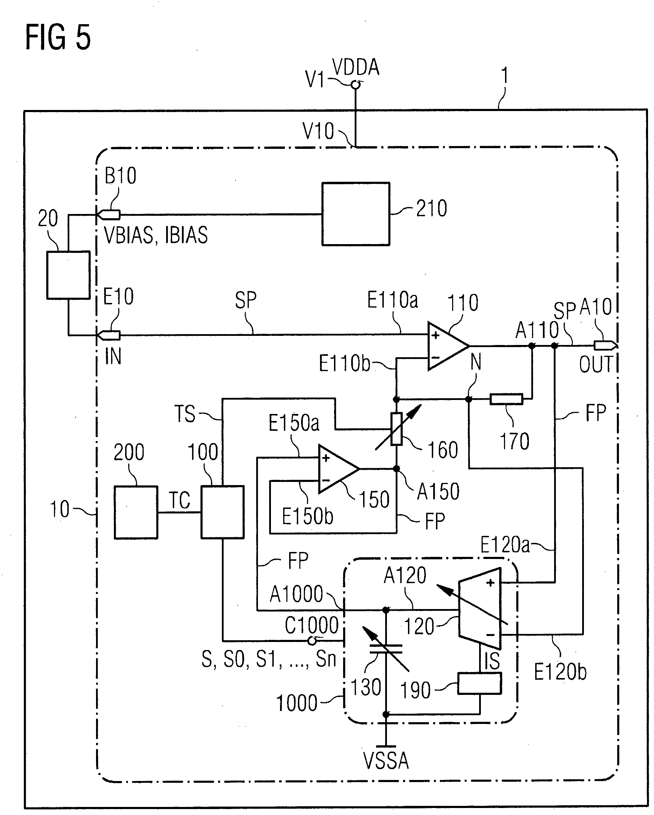

Figure 5 shows an embodiment of an electric amplifier circuit 10, wherein, in contrast to the embodiment of the electric amplifier circuit shown in Figure 2, the input terminal E120b of the amplifier component 120 is coupled to the node N between input terminal E110b of the amplifier component 110 and the resistor 170. The amplifier component 120 may be configured as a transconductance amplifier and the input terminal E120b may be configured as the negative input terminal of the transconductance amplifier 120.

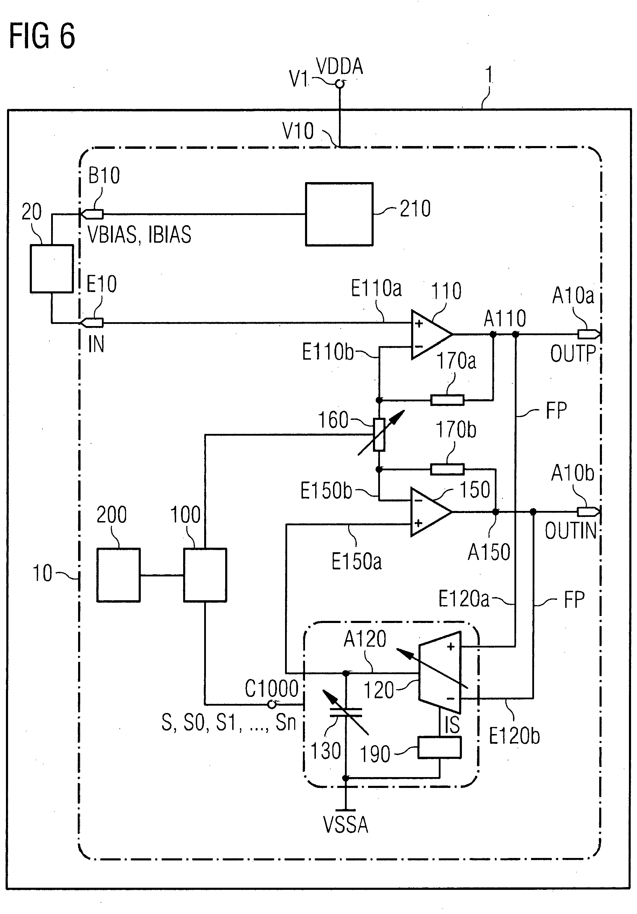

Figure 6 shows an embodiment of an electric amplifier circuit 10 being configured with a differential output terminal A10 comprising output connectors A10a and A10b. Output connector A10a may be configured as the positive output for outputting an output signal OUTP and output connector A10b may be configured as the negative output for outputting a negative output signal OUTN. The output terminal A110 of the amplifier component 110 is connected to the output connector A10a. The input connector E110b of the amplifier component 110 is coupled to the output terminal A110 of the amplifier component 110 via resistor 170a.

In contrast to the embodiment of the electric amplifier circuit 10 of Figure 2 the electric device 150 is configured as an amplifier component forming an additional amplifier stage. The input terminal E150a of the amplifier component 150 is connected to the output terminal A120 of the amplifier component 120. The input terminal E150b of the amplifier component 150 is coupled to the input terminal E110b of amplifier component 110 via the resistor 160 and to the output terminal A150 of the amplifier component 150 via the resistor 170b. The output terminal A150 of the amplifier component 150 is connected to the output connector A10b. The amplifier component 150 may be configured as a differential amplifier, wherein the input terminal E150a is configured as the positive input terminal and the input terminal E150b is configured as the negative input terminal.

The input terminal E120a of the amplifier component 120 is coupled, for example directly connected, to the output terminal A110 of the amplifier component 110, i.e. to the output connector A10a of the output terminal A10. The input terminal E120b of the amplifier component 120 is coupled, for example directly connected, to the output terminal A150 of the amplifier component 150, i.e. to the output connector A10b of the output terminal A10. The signal path between output connector A10a and input terminal E120a of the amplifier component as well as the signal path between output connector A10b and input terminal E120b of the amplifier component 120 are part of the feedback path FP. The amplifier component 120 may be configured as a transconductance amplifier, wherein the input terminal E120a may be configured as the positive input terminal and the input terminal E120b may be configured as the negative input terminal.

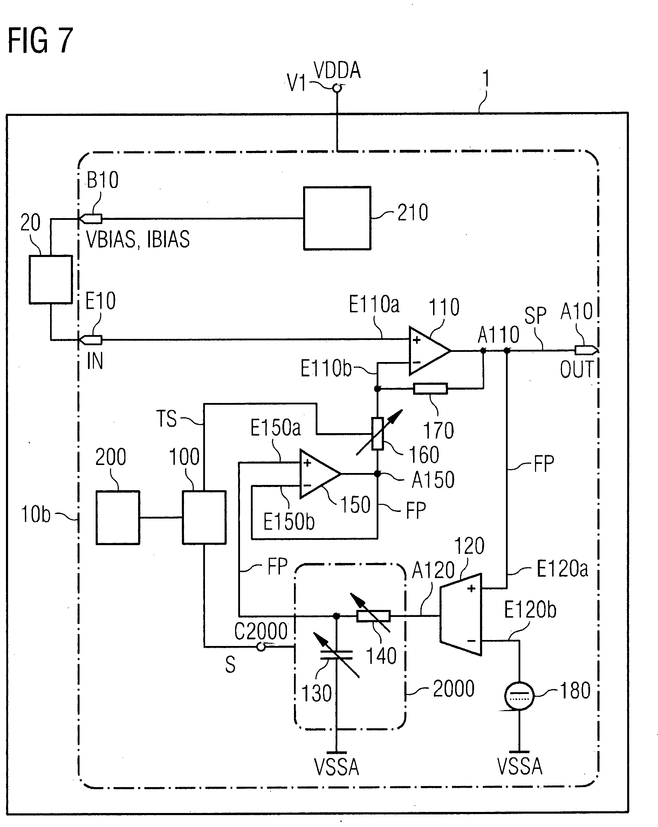

Figure 7 shows another embodiment of the electric amplifier circuit 10 for amplifying the output signal of the microphone 20 comprising a variable filter circuit 2000 having a variable corner frequency. Components of the electric amplifier circuit of Figure 7 being identical to components of the electric amplifier circuit of Figure 2 are reference by the same signs. The electric amplifier circuit 10 of Figure 7 comprises current/voltage generator 210 to generate the bias current IBIAS/bias voltage VBIAS to operate the microphone 20 and the amplifier component 110 arranged between input terminal E10 for applying the input signal IN and output terminal A10 for generating the output signal OUT. The electric amplifier circuit further comprises the amplifier component 120 which may be formed as a current amplifier component, for example, an operational transconductance amplifier component, the voltage follower 150, the variable resistor 160, the resistor 170 and the voltage generator 180 to generate the voltage Vref. The electric amplifier circuit further comprises the control circuit 100 and the storage circuit 200. For a detailed description of the components referenced in Figure 7 with the same reference signs as in Figure 2, reference is made to the description of the electric amplifier circuit of Figure 2.

The electric amplifier circuit further comprises a variable filter 2000 being arranged between an output terminal A120 of the amplifier component 120 and the input side E150a of the voltage follower 150. The variable filter 2000 may comprise the capacitor 130 and a resistor 140. The capacitor 130 is arranged between the feedback path FP and a terminal to apply the reference potential VSSA. The capacitor 130 may be connected to the feedback path FP between the resistor 140 and the voltage follower 150. The resistor 140 is arranged between the output terminal A120 of the amplifier component 120 and the voltage follower 150.

The variable filter circuit is configured as RC network. The capacitor 130 and the resistor 140 form a low pass filter in the feedback path FP. At least one of the capacitor 130 and the resistor 140 is configured as a variable component. That means that the capacitance of the capacitor 130 and/or the resistance of the resistor 140 are/is variable. The capacitance of capacitor 130 and/or the resistance of resistor 140 may be set in dependence on the control signal S generated by the control circuit 100 and applied to a control terminal C2000 of the variable filter. The control circuit 100 is coupled to the storage circuit 200 for storing a value/trim code which specifies the gain setting of the amplifier component 110. The control circuit 100 is configured to read out the value/trim code stored in storage circuit 200 and generate the control signal TS to set the resistance of variable resistor 160 and the control signal S to set the capacitance of capacitor 130 and/or the resistance of resistor 140 of the variable filter 2000.

The variable capacitor 130 and/or the variable resistor 140 are configured as the electric component of the variable filter 2000 which are configured for setting the corner frequency of the variable filter 2000 by changing the impedance of the RC filter network. The variable capacitor and/or the variable resistor are configured to set the corner frequency of the variable filter circuit 2000 in dependence on the control signal S and thus in dependence on the gain of the amplifier component 100.

The electric amplifier circuit 10 of Figure 7 may be modified in the same way as the electric amplifier circuit of Figure 2 is modified according to Figures 4, 5 and 6. The embodiment of the electric amplifier circuit shown in Figure 7 enables that the corner frequency of the variable filter 2000 is adjusted in dependence on the gain of the amplifier component 110 so that the phase shift between the input signal IN and the output signal OUT nearly stays constant for different gain settings of the amplifier component 110.

According to the embodiments of the electric amplifier circuit of Figure 2 and Figure 4, the control circuit 100 may be configured to set the gain of the amplifier component 110 during operation of the electric amplifier circuit and to adjust the corner frequency of the variable filter 1000, 2000 in dependence on the gain of the differential amplifier component. It is also possible to measure the frequency response of the electric amplifier circuit between the input signal IN applied at the input terminal E10 and the output signal OUT generated at the output terminal A10 and adjust the corner frequency of the variable filter circuit 1000, 2000 once during the production of the electric amplifier circuit. A trim code to set the corner frequency may be stored in storage circuit 200. The control circuit 100 is configured to read out the stored trim code and to adjust the corner frequency of the variable filter 1000, 2000 accordingly.

Many modifications and other embodiments set forth herein will come to mind to one skilled in the art to which the embodiments pertain having the benefit of the teachings presented in the foregoing descriptions and the associated drawings. Therefore, it is to be understood that the description and the claims are not to be limited to the specific embodiments disclosed and that modifications and other embodiments are intended to be included within the scope of the appended claims. It is intended that embodiments cover the modifications and variations of the embodiments provided they come within the scope of the appended claims and their equivalents. Although specific terms are employed herein, they are used in a generic and descriptive sense only and not for purposes of limitation.

List of Reference Signs

| | |
|---|---|
| 1 | microphone chip |
| 10 | electric amplifier circuit |
| 20 | microphone |
| 30 | substrate |
| 40 | via hole |
| 50 | package |
| 100 | control circuit |
| 110 | amplifier component |
| 120 | amplifier component |
| 130 | capacitor |
| 140 | resistor |
| 150 | voltage follower |
| 160 | variable resistor |
| 170 | resistor |

180 voltage source
190 setting circuit
200 storage circuit
210 voltage and/or current generator circuit

**Claims**

1. An electric amplifier circuit for amplifying an output signal of a microphone, comprising:

   - an input terminal (E10) to apply the output signal of the microphone (20),
   - an output terminal (A10) to output an output signal of the amplifier circuit (10),
   - an amplifier component (110) having a first input terminal (E110a) for applying a first input signal, a second input terminal (E110b) for applying a second input signal and an output terminal (A110) for outputting an output signal (OUT) of the amplifier component, wherein the first input terminal (E110a) of the amplifier component (110) is coupled to the input terminal (E10) of the amplifier circuit, and the output terminal (A110) of the amplifier component (110) is coupled to the output terminal (A10) of the amplifier circuit,
   - a feedback path (FP) being coupled between the output terminal (A110) of the amplifier component (110) and the second input terminal (E110b) of the amplifier component (110),
   - a variable filter circuit (1000, 2000) having a variable corner frequency,
   - a storage circuit (200) for storing a value (TC) to set a gain of the amplifier component (110),
   - wherein the variable filter circuit (1000, 2000) is arranged in the feedback path (FP),
   - wherein the variable filter circuit (1000, 2000) comprises an electric component (120, 130, 140) being configured for setting the corner frequency of the variable filter circuit (1000, 2000) in dependence on the value (TC) stored in the storage circuit (200).

2. The electric amplifier circuit as claimed in claim 1, wherein the electric component (120, 130, 140) is configured to set the corner frequency of the variable filter circuit (1000, 2000) in dependence on a gain of the amplifier component (110).

3. The electric amplifier circuit as claimed in claims 1 or 2, comprising:

   - a control circuit (100) to control the variable filter circuit, the control circuit (100) being configured to generate a control signal (S, S0, S1, ..., Sn) to control the corner frequency of the variable filter circuit (1000, 2000),

   - wherein the variable filter circuit (1000, 2000) comprises a control terminal (C1000, C2000) to apply the control signal (S, S0, S1, ..., Sn) generated by the control circuit (100) to control the variable filter circuit (200),
   - wherein the electric component (120, 130, 140) of the variable filter circuit (1000, 2000) is configured to set the corner frequency of the variable filter circuit in dependence on the control signal (S, S0, S1, ..., Sn) generated by the control circuit (100) to control the variable filter circuit.

4. The electric amplifier circuit as claimed in claim 3, wherein the control circuit (100) is configured to generate the control signal (S, S0, S1, ..., Sn) to set the corner frequency of the variable filter circuit (1000, 2000) in dependence on a gain of the amplifier component (110).

5. The electric amplifier circuit as claimed in any of claims 1 to 4, comprising:

   - a first resistor (160),
   - a second resistor (170),
   - a voltage follower (150), wherein the voltage follower (150) is arranged in the feedback path (FP) between the variable filter circuit (1000, 2000) and the second input terminal (E110b) of the amplifier component (110),
   - wherein the first resistor (160) is arranged in the feedback path (FP) between an output terminal (A150) of the voltage follower (150) and the second input terminal (E110b) of the amplifier component (110),
   - wherein the second resistor (170) is directly connected to the output terminal (A110) of the amplifier component (110) and the second input terminal (E110b) of the amplifier component (110),
   - wherein the amplifier component (110) is configured such that the gain of the amplifier component (110) is dependent on the relationship between the first and second resistors (160, 170).

6. The electric amplifier circuit as claimed in claim 5, comprising:

   - a control circuit (100) to set the gain of the amplifier component (110),
   - a storage circuit (200),
   - wherein at least one of the first and second resistor (160, 170) is configured as a variable resistor,
   - wherein the control circuit (100) is configured to set the resistance of the first resistor (160) in dependence on the value stored in the storage circuit (200),

- wherein the control circuit (100) to control the variable filter circuit (1000, 2000) is configured to generate the control signal (S, S0, S1, S2, ..., Sn) in dependence on the value stored in the storage circuit (200).

7. The electric amplifier circuit as claimed in any of claims 1 to 6,

   - wherein the electric component comprises a variable amplifier component (120) having a variable transconductance,
   - wherein the variable filter circuit (1000) is configured to set the transconductance of the variable amplifier component (120) in dependence on the control signal (S0, S1, ..., Sn) generated by the control circuit (100) to control the variable filter circuit (1000).

8. The electric amplifier circuit as claimed in claim 7,

   - wherein the variable filter circuit (1000) comprises a capacitor (130),
   - wherein the variable amplifier component comprises an output terminal (A120),
   - wherein the capacitor (130) is arranged between the output terminal (A120) of the amplifier component (120) and a terminal to apply a reference potential (VSSA) .

9. The electric amplifier circuit as claimed in claims 7 or 8, wherein the variable amplifier component (120) is configured as a operational transconductance amplifier component.

10. The electric amplifier circuit as claimed in any of claims 7 to 9,

    - wherein the variable filter circuit (1000) comprises a setting circuit (190) to generate a control signal (IS) to set the transconductance of the variable amplifier component (120),
    - wherein the setting circuit (190) is configured to generate the control signal (IS) to set the transconductance of the variable amplifier component (120) in dependence on the control signal (S0, S1, ..., Sn) generated by the control circuit (100) to control the variable filter circuit (1000).

11. The electric amplifier circuit as claimed in claim 10, wherein the setting circuit (190) comprises a controllable current mirror circuit, wherein the setting circuit (190) is configured to set the mirror ratio of the controllable current mirror circuit in dependence on the control signal (S1, S2, ..., Sn) generated by the control circuit (100) to control the variable filter circuit (1000).

12. The electric amplifier circuit as claimed in any of claims 1 to 6,

    - wherein the electric component comprises a variable capacitor (130) having a variable capacitance,
    - wherein the variable filter circuit (1000, 2000) is configured to set the capacitance of the variable capacitor (130) in dependence on the control signal (S) generated by the control circuit (100) to control the variable filter circuit (1000, 2000).

13. The electric amplifier circuit as claimed in any of claims 1 to 6,

    - wherein the variable filter circuit (2000) comprises a capacitor (130),
    - wherein the electric component comprises a variable resistor (140) having a variable resistance,
    - wherein the capacitor (130) is arranged between the variable resistor (140) and a terminal to apply a reference potential (VSSA),
    - wherein the variable filter circuit (2000) is configured to set the resistance of the variable resistor (140) in dependence on the control signal (S) generated by the control circuit (100) to control the variable filter circuit (2000).

14. The electric amplifier circuit as claimed in claim 13, comprising:

    - a current amplifier component (120) having an input terminal (E120a) being coupled to the output terminal (A10) of the amplifier circuit and an output terminal (A120) being coupled to the variable resistor (140) of the variable filter circuit,
    - wherein the variable resistor (140) of the variable filter circuit is arranged in the feedback path (FP) between the output terminal (A120) of the current amplifier component (120) and the input terminal (E150) of the voltage follower.

15. A microphone chip, comprising:

    - an electric amplifier circuit (10) as claimed in any of claims 1 to 14,
    - the microphone (20), wherein the microphone is coupled to the input terminal (E10) of the amplifier circuit (10).

**Patentansprüche**

1. Elektrische Verstärkerschaltung zum Verstärken eines Ausgangssignals eines Mikrofons, Folgendes umfassend:

- einen Eingangsanschluss (E10) zum Anlegen des Ausgangssignals des Mikrofons (20),
- einen Ausgangsanschluss (A10) zum Ausgeben eines Ausgangssignals der Verstärkerschaltung (10),
- eine Verstärkerkomponente (110) mit einem ersten Eingangsanschluss (E110a), um ein erstes Eingangssignal anzulegen, einem zweiten Eingangsanschluss (E110b), um ein zweites Eingangssignal anzulegen, und einem Ausgangsanschluss (A110), um ein Ausgangssignal (OUT) der Verstärkerkomponente auszugeben, wobei der erste Eingangsanschluss (E110a) der Verstärkerkomponente (110) auf den Eingangsanschluss (E10) der Verstärkerschaltung aufgeschaltet ist, und der Ausgangsanschluss (A110) der Verstärkerkomponente (110) auf den Ausgangsanschluss (A10) der Verstärkerschaltung aufgeschaltet ist,
- einen Rückkopplungspfad (FP), der zwischen dem Ausgangsanschluss (A110) der Verstärkerkomponente (110) und dem zweiten Eingangsanschluss (E110b) der Verstärkerkomponente (110) aufgeschaltet ist,
- eine variable Filterschaltung (1000, 2000) mit einer variablen Eckfrequenz,
- eine Speicherschaltung (200), um einen Wert (TC) zum Einstellen einer Verstärkung der Verstärkerkomponente (110) zu speichern,
- wobei die variable Filterschaltung (1000, 2000) im Rückkopplungspfad (FP) angeordnet ist,
- wobei die variable Filterschaltung (1000, 2000) eine elektrische Komponente (120, 130, 140) umfasst, die dazu ausgelegt ist, die Eckfrequenz der variablen Filterschaltung (1000, 2000) in Abhängigkeit von dem in der Speicherschaltung (200) gespeicherten Wert (TC) einzustellen.

2. Elektrische Verstärkerschaltung nach Anspruch 1, wobei die elektrische Komponente (120, 130, 140) dazu ausgelegt ist, die Eckfrequenz der variablen Filterschaltung (1000, 2000) in Abhängigkeit von einer Verstärkung der Verstärkerkomponente (110) einzustellen.

3. Elektrische Verstärkerschaltung nach den Ansprüchen 1 oder 2, Folgendes umfassend:

- eine Steuerschaltung (100) zum Steuern der variablen Filterschaltung, wobei die Steuerschaltung (100) dazu ausgelegt ist, ein Steuersignal (S, S0, S1, ..., Sn) zum Steuern der Eckfrequenz der variablen Filterschaltung (1000, 2000) zu generieren,
- wobei die variable Filterschaltung (1000, 2000) einen Steueranschluss (C1000, C2000) zum Anlegen des durch die Steuerschaltung (100) zum Steuern der variablen Filterschaltung (2000) generierten Steuersignals (S, S0, S1, ..., Sn) umfasst,
- wobei die elektrische Komponente (120, 130, 140) der variablen Filterschaltung (1000, 2000) dazu ausgelegt ist, die Eckfrequenz der variablen Filterschaltung in Abhängigkeit von dem durch die Steuerschaltung (100) zum Steuern der variablen Filterschaltung generierten Steuersignal (S, S0, S1, ..., Sn) einzustellen.

4. Elektrische Verstärkerschaltung nach Anspruch 3, wobei die Steuerschaltung (100) dazu ausgelegt ist, das Steuersignal (S, S0, S1, ..., Sn) zum Einstellen der Eckfrequenz der variablen Filterschaltung (1000, 2000) in Abhängigkeit von einer Verstärkung der Verstärkerkomponente (110) zu generieren.

5. Elektrische Verstärkerschaltung nach einem der Ansprüche 1 bis 4, Folgendes umfassend:

- einen ersten Widerstand (160),
- einen zweiten Widerstand (170),
- einen Spannungsnachläufer (150), wobei der Spannungsnachläufer (150) im Rückkopplungspfad (FP) zwischen der variablen Filterschaltung (1000, 2000) und dem zweiten Eingangsanschluss (E110b) der Verstärkerkomponente (110) angeordnet ist,
- wobei der erste Widerstand (160) im Rückkopplungspfad (FP) zwischen einem Ausgangsanschluss (A150) des Spannungsnachläufers (150) und dem zweiten Eingangsanschluss (E110b) der Verstärkerkomponente (110) angeordnet ist,
- wobei der zweite Widerstand (170) direkt an den Ausgangsanschluss (A110) der Verstärkerkomponente (110) und den zweiten Eingangsanschluss (E110b) der Verstärkerkomponente (110) angeschlossen ist,
- wobei die Verstärkerkomponente (110) so ausgelegt ist, dass die Verstärkung der Verstärkerkomponente (110) vom Verhältnis zwischen dem ersten und zweiten Widerstand (160, 170) abhängt.

6. Elektrische Verstärkerschaltung nach Anspruch 5, Folgendes umfassend:

- eine Steuerschaltung (100) zum Einstellen der Verstärkung der Verstärkerkomponente (110),
- eine Speicherschaltung (200),
- wobei der erste und/oder zweite Widerstand (160, 170) als variabler Widerstand ausgelegt ist/sind,
- wobei die Steuerschaltung (100) dazu ausgelegt ist, den Widerstandswert des ersten Widerstands (160) in Abhängigkeit von dem in der Speicherschaltung (200) gespeicherten Wert einzustellen,

- wobei die Steuerschaltung (100) zum Steuern der variablen Filterschaltung (1000, 2000) dazu ausgelegt ist, das Steuersignal (S, S0, S1, S2, ..., Sn) in Abhängigkeit von dem in der Speicherschaltung (200) gespeicherten Wert zu generieren.

7. Elektrische Verstärkerschaltung nach einem der Ansprüche 1 bis 6,

- wobei die elektrische Komponente eine variable Verstärkerkomponente (120) mit einem variablen Gegenwirkleitwert umfasst,
- wobei die variable Filterschaltung (1000) dazu ausgelegt ist, den Gegenwirkleitwert der variablen Verstärkerkomponente (120) in Abhängigkeit von dem durch die Steuerschaltung (100) zum Steuern der variablen Filterschaltung (1000) generierten Steuersignal (S0, S1, ..., Sn) einzustellen.

8. Elektrische Verstärkerschaltung nach Anspruch 7,

- wobei die variable Filterschaltung (1000) einen Kondensator (130) umfasst,
- wobei die variable Verstärkerkomponente einen Ausgangsanschluss (A120) umfasst,
- wobei der Kondensator (130) zwischen dem Ausgangsanschluss (A120) der Verstärkerkomponente (120) und einem Anschluss zum Anlegen eines Bezugspotentials (VSSA) angeordnet ist.

9. Elektrische Verstärkerschaltung nach den Ansprüchen 7 oder 8, wobei die variable Verstärkerkomponente (120) als Operationsgegenwirkleitwertverstärkerkomponente ausgelegt ist.

10. Elektrische Verstärkerschaltung nach einem der Ansprüche 7 bis 9,

- wobei die variable Filterschaltung (1000) eine Einstellschaltung (190) zum Generieren eines Steuersignals (IS) zum Einstellen des Gegenwirkleitwerts der variablen Verstärkerkomponente (120) umfasst,
- wobei die Einstellschaltung (190) dazu ausgelegt ist, das Steuersignal (IS) zum Einstellen des Gegenwirkleitwerts der variablen Verstärkerkomponente (120) in Abhängigkeit von dem durch die Steuerschaltung (100) zum Steuern der variablen Filterschaltung (1000) generierten Steuersignal (S0, S1, ..., Sn) zu generieren.

11. Elektrische Verstärkerschaltung nach Anspruch 10, wobei die Einstellschaltung (190) eine steuerbare Stromspiegelschaltung umfasst, wobei die Einstellschaltung (190) dazu ausgelegt ist, das Spiegelverhältnis der steuerbaren Stromspiegelschaltung in Abhängigkeit von dem durch die Steuerschaltung (100) zum Steuern der variablen Filterschaltung (1000) generierten Steuersignal (S1, S2, ..., Sn) einzustellen.

12. Elektrische Verstärkerschaltung nach einem der Ansprüche 1 bis 6,

- wobei die elektrische Komponente einen variablen Kondensator (130) mit einer variablen Kapazität umfasst,
- wobei die variable Filterschaltung (1000, 2000) dazu ausgelegt ist, die Kapazität des variablen Kondensators (130) in Abhängigkeit von dem durch die Steuerschaltung (100) zum Steuern der variablen Filterschaltung (1000, 2000) generierten Steuersignal (S) einzustellen.

13. Elektrische Verstärkerschaltung nach einem der Ansprüche 1 bis 6,

- wobei die variable Filterschaltung (2000) einen Kondensator (130) umfasst,
- wobei die elektrische Komponente einen variablen Widerstand (140) mit einem variablen Widerstandswert umfasst,
- wobei der Kondensator (130) zwischen dem variablen Widerstand (140) und einen Anschluss zum Anlegen eines Bezugspotentials (VSSA) angeordnet ist,
- wobei die variable Filterschaltung (2000) dazu ausgelegt ist, den Widerstandswert des variablen Widerstands (140) in Abhängigkeit von dem durch die Steuerschaltung 100) zum Steuern der variablen Filterschaltung (2000) generierten Steuersignal (S) einzustellen.

14. Elektrische Verstärkerschaltung nach Anspruch 13, Folgendes umfassend:

- eine Stromverstärkerkomponente (120) mit einem Eingangsanschluss (E120a), der auf den Ausgangsanschluss (A10) der Verstärkerschaltung aufgeschaltet ist, und einem Ausgangsanschluss (A120), der auf den variablen Widerstand (140) der variablen Filterschaltung aufgeschaltet ist,
- wobei der variable Widerstand (140) der variablen Filterschaltung im Rückkopplungspfad (FP) zwischen dem Ausgangsanschluss (A120) der Stromverstärkerkomponente (120) und dem Eingangsanschluss (E150) des Spannungsnachläufers angeordnet ist.

**15.** Mikrofon-Chip, Folgendes umfassend:

- eine elektrische Verstärkerschaltung (10) nach einem der Ansprüche 1 bis 14,
- das Mikrofon (20), wobei das Mikrofon auf den Eingangsanschluss (E10) der Verstärkerschaltung (10) aufgeschaltet ist.

**Revendications**

**1.** Circuit amplificateur électrique destiné à amplifier un signal de sortie d'un microphone, comprenant :

- une borne d'entrée (E10) pour appliquer le signal de sortie du microphone (20),
- une borne de sortie (A10) pour sortir un signal de sortie du circuit amplificateur (10),
- un composant amplificateur (110) comportant une première borne d'entrée (E110a) destinée à appliquer un premier signal d'entrée, une deuxième borne d'entrée (E110b) destinée à appliquer un deuxième signal d'entrée et une borne de sortie (A110) destinée à sortir un signal de sortie (OUT) du composant amplificateur, sachant que la première borne d'entrée (E110a) du composant amplificateur (110) est couplée à la borne d'entrée (A110) du circuit amplificateur, et la borne de sortie (A110) du composant amplificateur (110) est couplée à la borne de sortie (E10) du circuit amplificateur,
- un chemin de rétroaction (FP) qui est couplé entre la borne de sortie (A110) du composant amplificateur (110) et la deuxième borne d'entrée (E110b) du composant amplificateur (110),
- un circuit de filtre variable (1000, 2000) ayant une fréquence d'angle variable,
- un circuit de stockage (200) destiné à stocker une valeur (TC) pour régler un gain du composant amplificateur (110),
- sachant que le circuit de filtre variable (1000, 2000) est agencé dans le chemin de rétroaction (FP),
- sachant que le circuit de filtre variable (1000, 2000) comprend un composant électrique (120, 130, 140) qui est configuré pour régler la fréquence d'angle du circuit de filtre variable (1000, 2000) en fonction de la valeur (TC) stockée dans le circuit de stockage (200).

**2.** Le circuit amplificateur électrique tel que revendiqué dans la revendication 1, sachant que le composant électrique (120, 130, 140) est configuré pour régler la fréquence d'angle du circuit de filtre variable (1000, 2000) en fonction d'un gain du composant amplificateur (110).

**3.** Le circuit amplificateur électrique tel que revendiqué dans les revendications 1 ou 2, comprenant :

- un circuit de commande (100) pour commander le circuit de filtre variable, le circuit de commande (100) étant configuré pour générer un signal de commande (S, S0, S1, ..., Sn) pour commander la fréquence d'angle du circuit de filtre variable (1000, 2000),
- sachant que le circuit de filtre variable (1000, 2000) comprend une borne de commande (C1000, C2000) pour appliquer le signal de commande (S, S0, S1, ..., Sn) généré par le circuit de commande (100) pour commander le circuit de filtre variable (2000),
- sachant que le composant électrique (120, 130, 140) du circuit de filtre variable (1000, 2000) est configuré pour ajuster la fréquence d'angle du circuit de filtre variable en fonction du signal de commande (S, S0, S1, ..., Sn) généré par le circuit de commande (100) pour commander le circuit de filtre variable.

**4.** Le circuit amplificateur électrique tel que revendiqué dans la revendication 3, sachant que le circuit de commande (100) est configuré pour générer le signal de commande (S, S0, S1, ..., Sn) pour régler la fréquence d'angle du circuit de filtre variable (1000, 2000) en fonction d'un gain du composant amplificateur (110).

**5.** Le circuit amplificateur électrique tel que revendiqué dans l'une quelconque des revendications 1 à 4, comprenant :

- une première résistance (160),
- une deuxième résistance (170),
- un suiveur de tension (150), sachant que le suiveur de tension (150) est agencé dans le chemin de rétroaction (FP) entre le circuit de filtre variable (1000, 2000) et la deuxième borne d'entrée (E110b) du composant amplificateur (110),
- sachant que la première résistance (160) est agencée dans le chemin de rétroaction (FP) entre une borne de sortie (A150) du suiveur de tension (150) et la deuxième borne d'entrée (E110b) du composant amplificateur (110),
- sachant que la deuxième résistance (170) est directement connectée à la borne de sortie (A110) du composant amplificateur (110) et à la deuxième borne d'entrée (E110b) du composant amplificateur (110),
- sachant que le composant amplificateur (110) est configuré de telle sorte que le gain du composant amplificateur (110) soit fonction de la relation entre la première et la deuxième résistance (160, 170).

**6.** Le circuit amplificateur électrique tel que revendiqué dans la revendication 5, comprenant :

- un circuit de commande (100) pour régler le gain du composant amplificateur (110),
- un circuit de stockage (200),
- sachant qu'au moins l'une de la première et de la deuxième résistance (160, 170) est configurée comme résistance variable,
- sachant que le circuit de commande (100) est configuré pour régler la valeur ohmique de la première résistance (160) en fonction de la valeur stockée dans le circuit de stockage (200),
- sachant que le circuit de commande (100) pour commander le circuit de filtre variable (1000, 2000) est configuré pour générer le signal de commande (S, S0, S1, S2, ..., Sn) en fonction de la valeur stockée dans le circuit de stockage (200).

7. Le circuit amplificateur électrique tel que revendiqué dans l'une quelconque des revendications 1 à 6,

- sachant que le composant électrique comprend un composant amplificateur (120) variable ayant une transconductance variable,
- sachant que le circuit de filtre variable (1000) est configuré pour régler la transconductance du composant amplificateur (120) variable en fonction du signal de commande (S0, S1, ..., Sn) généré par le circuit de commande (100) pour commander le circuit de filtre variable (1000).

8. Le circuit amplificateur électrique tel que revendiqué dans la revendication 7,

- sachant que le circuit de filtre variable (1000) comprend un condensateur (130),
- sachant que le composant amplificateur variable comprend une borne de sortie (A120),
- sachant que le condensateur (130) est agencé entre la borne de sortie (A120) du composant amplificateur (120) et une borne pour appliquer un potentiel de référence (VSSA).

9. Le circuit amplificateur électrique tel que revendiqué dans les revendications 7 ou 8, sachant que le composant amplificateur (120) variable est configuré comme composant amplificateur de transconductance opérationnel.

10. Le circuit amplificateur électrique tel que revendiqué dans l'une quelconque des revendications 7 à 9,

- sachant que le circuit de filtre variable (1000) comprend un circuit de réglage (190) pour générer un signal de commande (IS) pour régler la transconductance du composant amplificateur (120) variable,

- sachant que le circuit de réglage (190) est configuré pour générer le signal de commande (IS) pour régler la transconductance du composant amplificateur (120) variable en fonction du signal de commande (S0, S1, ..., Sn) généré par le circuit de commande (100) pour commander le circuit de filtre variable (1000).

11. Le circuit amplificateur électrique tel que revendiqué dans la revendication 10, sachant que le circuit de réglage (190) comprend un circuit de miroir de courant apte à être commandé, sachant que le circuit de réglage (190) est configuré pour régler le rapport de miroir du circuit de miroir de courant apte à être commandé en fonction du signal de commande (S1, S2, ..., Sn) généré par le circuit de commande (100) pour commander le circuit de filtre variable (1000).

12. Le circuit amplificateur électrique tel que revendiqué dans l'une quelconque des revendications 1 à 6,

- sachant que le composant électrique comprend un condensateur variable (130) ayant une capacitance variable,
- sachant que le circuit de filtre variable (1000, 2000) est configuré pour régler la capacitance du condensateur (130) variable en fonction du signal de commande (S) généré par le circuit de commande (100) pour commander le circuit de filtre variable (1000, 2000).

13. Le circuit amplificateur électrique tel que revendiqué dans l'une quelconque des revendications 1 à 6,

- sachant que le circuit de filtre variable (2000) comprend un condensateur (130),
- sachant que le composant électrique comprend une résistance (140) variable ayant une valeur ohmique variable,
- sachant que le condensateur (130) est agencé entre la résistance (140) variable et une borne pour appliquer un potentiel de référence (VSSA),
- sachant que le circuit de filtre variable (2000) est configuré pour régler la valeur ohmique de la résistance (140) variable en fonction du signal de commande (S) généré par le circuit de commande (100) pour commander le circuit de filtre variable (2000).

14. Le circuit amplificateur électrique tel que revendiqué dans la revendication 13, comprenant :

- un composant amplificateur de courant (120) comportant une borne d'entrée (E120a) couplée à la borne de sortie (A10) du circuit amplificateur et une borne de sortie (A120) couplée à la résistance (140) variable du circuit de filtre variable,
- sachant que la résistance (140) variable du circuit de filtre variable est agencée dans le chemin de rétroaction (FP) entre la borne de sortie (A120) du composant amplificateur de courant (120) et la borne d'entrée (E150) du suiveur de tension.

15. Puce de microphone, comprenant :

- un circuit amplificateur électrique (10) tel que revendiqué dans l'une quelconque des revendications 1 à 14,
- le microphone (20), sachant que le microphone est couplé à la borne d'entrée (E10) du circuit amplificateur (10).

## FIG 1A

## FIG 1B

FIG 2

FIG 3

# FIG 4

# FIG 5

## FIG 6

FIG 7

**EP 2 849 337 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1298795 A2